# EUROPEAN PATENT APPLICATION

(11) **EP 3 945 589 A1**
(43) Date of publication of application: **02.02.2022**
(21) Application number: 20305863.1
(22) Date of filing: 27.07.2020
(51) Int. Cl.: H01L 27/30, H01L 51/00

(54) **METHOD FOR MANUFACTURING A SEMICONDUCTOR MODULE AND SEMICONDUCTOR MODULE THUS OBTAINED**

(71) Applicant: Armor, 44100 Nantes (FR); Bayerisches Zentrum für Angewandte Energieforschung e. V., 97074 Würzburg (DE)
(72) Inventor: DERENNES, Christophe, 44310 Saint Philbert de Grand Lieu (FR); HAU, Damien, 44115 BASSE GOULAINE (FR); ALLAIS, François, 44115 BASSE GOULAINE (FR); LE ROUX, Emmanuel, 44100 NANTES (FR); MWAURA, Jeremiah, ANDOVER, MA01810 (US); WAGNER, Michael, 91126 SCHWABACH (DE); EGELHAAF, Hans-Joachim, 90403 Nürnberg (DE); KUBIS, Peter, 90419 NÜRNBERG (DE)
(74) Representative: Lavoix

(57) **Abstract**

The invention relates to a method for manufacturing a semiconductor module (10) comprising at least two electrically connected semiconductor cells (16A, 16B, 16C), said semiconductor module comprising an insulating substrate (12) covered with a bottom layer (23) of a first electrically conductive material, each of the at least two semiconductor cells extending along a longitudinal direction (Y) of the insulating substrate.

The method comprises the steps of : a) forming a conductive strip (38) on the bottom layer, said conductive strip extending along the longitudinal direction and covering a portion of the bottom layer along a transversal direction (X) perpendicular to the longitudinal direction ; then b) depositing, on the bottom layer and conductive strip, a stack (20) comprising at least a functional layer (26) of a photoactive semiconductor material.

## Description

The invention relates to a method for manufacturing a semiconductor module comprising at least two electrically connected semiconductor cells, said semiconductor module comprising an insulating substrate covered with a bottom layer of a first electrically conductive material, each of the at least two semiconductor cells extending along a longitudinal direction of the insulating substrate.

The invention belongs more particularly to the field of organic semiconductor devices and organic photovoltaic (OPV) cells and modules.

A photovoltaic module is an electronic component which, exposed to light, produces electricity. Such a photovoltaic module typically comprises several electrically connected photovoltaic cells. Each cell includes at least one photo-active material, i.e., able to produce electricity from light. Such a material is for example an organic semiconductor.

Photovoltaic modules of the aforementioned type are described in documents US 7,932,124 and EP 2,478,559. Each cell of such a photovoltaic module is formed by a stack of strips, including a photo-active layer between two electrodes, said stack of strips being positioned on a substrate.

Such a stack, called active area, is separated into adjacent active areas by a so-called inactive area. Said inactive area allows electric isolation of the lower electrodes of two adjacent cells while connecting the upper electrode of each cell to the lower electrode of an adjacent cell. A photovoltaic module is obtained by forming several cells thus connected in series.

The performance of the photovoltaic module particularly involves producing the narrowest possible inactive areas, to maximize the size of the active areas. The geometric fill factor (GFF) of the photovoltaic module is defined as a ratio between the sum of the areas of the active areas of the photovoltaic cells and a total area of the substrate. The higher the GFF is, the better the electrical performance of the photovoltaic module is. In particular, obtaining a high GFF requires mastering the geometry of the electrical connections.

A known method for defining the inactive areas involves the scribing of parallel grooves in some of the layers by means of a laser source. Such a method is described in the publication "Patterning of organic photovoltaic modules by ultrafast laser" (Progress in Photovoltaics: Research and Applications 23.2 (2015): 238-246).

Laser scribing is a very delicate process. Indeed, an insufficient removal of the upper layers may lead to high ohmic resistance of the cells, while a too powerful laser source may damage the lower electrodes.

Femtosecond pulsed laser sources allow sufficiently accurate laser scribing. However, such laser sources remain too expensive for an industrial application.

Nanosecond lasers are known for a higher rate of material removal than femtosecond lasers. Indeed, a majority of material removal takes place by melting. The material is heated by the laser pulse from room temperature to its melting temperature and is eventually removed by evaporation and molten material expulsion.

However, with nanosecond lasers, the selective ablation of organic materials is difficult without affecting the conductivity of the lower electrodes.

The present invention aims to solve these problems in order to provide an efficient industrial manufacturing process of semiconductor modules, especially organic photovoltaic modules.

To such an end, the invention relates to a manufacturing method of the aforementioned type, comprising the following steps :
a) forming a conductive strip on the bottom layer, said conductive strip extending along the longitudinal direction and covering a first portion of the bottom layer along a transversal direction perpendicular to the longitudinal direction ; then
b) depositing, on the bottom layer and conductive strip, a stack comprising at least a functional layer of a photoactive semiconductor material ;
the method also comprising the following steps :
c) forming, in the bottom layer, a first groove defining a first and a second bottom electrodes, electrically isolated from one another, said first groove being distant from the conductive strip ;
d) forming a second groove in the stack, over the conductive strip ; said step d) being carried out after step b) ;
each of the first and second grooves extending along the longitudinal direction, said first and second grooves being parallel to each other and spaced from one another by a non-zero distance along the transversal direction ;
each of the first and second grooves being formed by a laser source at nanosecond range pulse duration ;
and
e) depositing a top layer of a second electrically conductive material over the stack deposited on each of the first and second bottom electrodes,
so that each of said first and second bottom electrodes forms respectively a first and a second semiconductor cell with the top layer and stack deposited over said bottom electrode ;
then
f) forming a connecting area between the top layer of the first semiconductor cell and the second bottom electrode, by printing a third electrically conductive material into the second groove.

By "nanosecond range pulse duration", it is meant that the pulse duration is inferior to 50 ns, more preferably inferior or equal to 20 ns.

According to other advantageous aspects of the invention, the manufacturing method includes one or more of the following features, considered alone or according to all technically possible combinations:
- the method comprises, before steps b) and c), a step i) of forming an insulating strip of an electrically insulating material on the bottom layer ; said insulating strip extending along the longitudinal direction and covering a second portion of the bottom layer perpendicularly to the longitudinal direction, said second portion being adjacent to the first portion covered by the conductive strip ; so that the stack formed in step b) covers the bottom layer, the insulating strip and the conductive strip ; and so that, in step c), the first groove is formed in the bottom layer through the insulating strip ;
- step c) is carried out after step b) and, in step c), a part of the first groove is formed in the stack ;
- the method includes a step g) of forming a third groove in the stack, said third groove extending along the longitudinal direction, said step g) being carried out after step b) ; the first, second and third grooves being parallel to each other and spaced from one another by a non-zero distance along the transversal direction ; the third groove being formed by a laser source at nanosecond range pulse duration ;
- step e) is carried out before step g) ; and the third groove is also formed in the top layer;
- step e) is also carried out before steps c) and d) ; and the first and second grooves are also formed in the top layer;
- steps e) and f) are simultaneously carried out after steps c), d) and g) ; and the second and third electrically conductive materials are preferably identical ;
- in step g), the third groove is formed over the conductive strip ;
- in step g), the third groove is formed at a non-zero distance from the conductive strip along the transversal direction ;
- the stack formed in step b) also comprises a first and a second intermediate layers, the functional layer being sandwiched between said first and second intermediate layers.

The invention further relates to a semiconductor module derived from or able to be derived from a method as described above.

According to other aspects of the invention, the semiconductor module includes one or more of the following features, considered alone or according to any technically possible combination(s):
- the semiconductor module comprises at least two electrically connected semiconductor cells extending along a longitudinal direction ; said semiconductor module also comprising : an insulating substrate ; a bottom layer of a first electrically conductive material, covering the insulating substrate ; a first groove formed in the bottom layer, defining a first and a second bottom electrodes ; a conductive strip formed on the bottom layer, at a distance from the first groove along a transversal direction perpendicular to the longitudinal direction ; a stack formed on the bottom layer and conductive strip, over each of the first and second bottom electrodes said stack comprising at least a functional layer of a photoactive semiconductor material ; a second groove formed in the stack, over the conductive strip, each of the first and second grooves extending along the longitudinal direction, said first and second grooves being parallel to each other and spaced from one another by a non-zero distance along the transversal direction ; a top layer formed over the stack deposited over each of the first and second bottom electrodes, so that each of said first and second bottom electrodes forms respectively a first and a second semiconductor cell with the top layer and stack deposited over said bottom electrode ; and a connecting area between the top layer of the first semiconductor cell and the second bottom electrode, said connecting area including a third electrically conductive material filling the second groove ;
- the semiconductor module also comprises an insulating strip formed on the bottom layer, adjacent to the conductive strip, the first groove comprising a bottom part in the bottom layer and a top part in the stack, the insulating strip being situated between said bottom and top parts of the first groove ;
- the first groove comprises sections adjacent along the longitudinal direction, each pair of adjacent sections being connected by a handover region so that, in said handover region, the first groove of each of the adjacent sections is extended by an inclined end forming a non-zero angle with the longitudinal direction, said inclined ends intersecting in the handover region, said inclined ends preferably extending over the conductive strip ;
- the semiconductor module also comprises a third groove formed in the stack, said third groove extending along the longitudinal direction ; the first, second and third grooves being parallel to each other and spaced from one another by a non-zero distance along the transversal direction ;
- the third groove comprises sections adjacent along the longitudinal direction, each pair of adjacent sections being connected by a handover region so that, in said handover region, the first groove of each of the adjacent sections is extended by an inclined end forming a non-zero angle with the longitudinal direction, said inclined ends intersecting in the handover region, said inclined ends preferably extending over the conductive strip ;
- the stack also comprises a first and a second intermediate layers, the functional layer being sandwiched between said first and second intermediate layers ;
- the semiconductor module is a photovoltaic module.

The invention will be better understood upon reading the following description, provided solely as a non-limiting example and done in reference to the drawings, in which:
Figure 1 is a sectional schematic view of a semiconductor module according to a first embodiment of the invention ;
Figure 2 is a sectional schematic view of a semiconductor module according to a second embodiment of the invention
Figure 3 is a detailed, top view of the semiconductor module of Figure 1 ;
Figure 4 is a sectional schematic view of a first intermediate state architecture forming a step of a manufacturing method of the semiconductor modules of Figures 1 and 2 ; and
Figure 5 is a detailed, top view of a second intermediate state architecture forming a step of a manufacturing method of the semiconductor module of Figure 1.

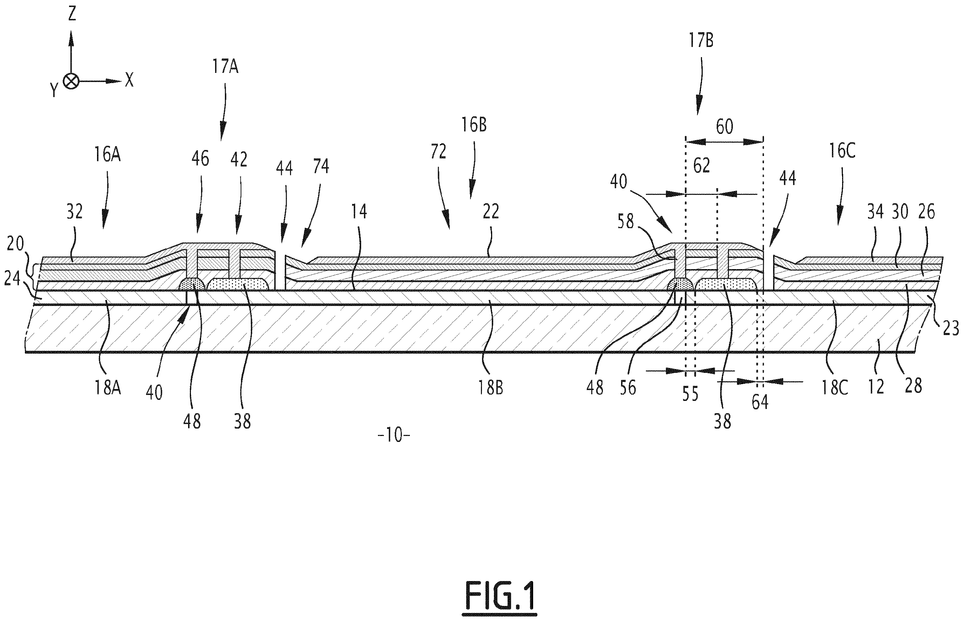

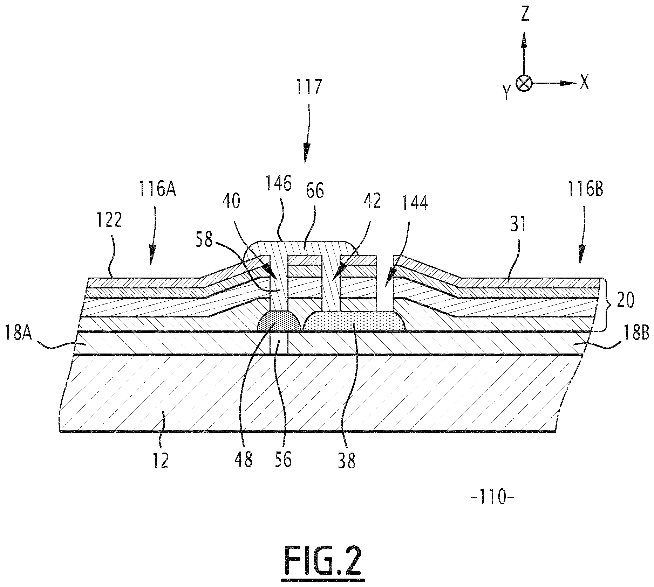

Figure 1 is a schematic sectional view of a semiconductor module 10 according to a first embodiment of the invention. Figure 2 is a schematic sectional view of a semiconductor module 110 according to a second embodiment of the invention.

The semiconductors modules 10 and 110 are similar, except for the differences detailed below. The semiconductors modules 10 and 110 will be described simultaneously, the common elements being designed by the same reference numbers.

The semiconductor module 10, 110 comprises a substrate 12, formed by a flexible sheet of electrically insulating material.

Preferably, the substrate 12 is made of a polymer material, such as a PET-type material (polyethylene terephthalate), or a PEN-type material (polyethylene naphthalate). Alternatively, the substrate 12 is made of metal foil or of flexible glass.

Preferably, the substrate 12 is transparent to visible light.

The substrate 12 particularly comprises a substantially planar surface 14. An orthogonal base (X, Y, Z) is considered, the surface 14 forming a plane (X, Y). The direction Z is considered as the stacking direction. In figure 1, the semiconductor module 10 is shown with dimensions along Z stretched relative to the dimensions along X, considered as the transversal direction.

Preferably, the substrate 12 has a thickness along Z comprised between 50 µm and 500 µm. More preferably, the thickness of substrate 12 is of approximately 125 µm.

The semiconductor module 10, 110 comprises at least two semiconductor cells 16A, 16B, 16C, 116A, 116B, positioned on the substrate 12. The semiconductor module 10 further comprises at least one electrical connection 17A, 17B, 117 between two semiconductor cells.

Preferably, as detailed below, the semiconductor module 10, 110 is a photovoltaic module and the semiconductor cells 16A, 16B, 16C are photovoltaic cells.

Each of the semiconductor cells 16A, 16B, 16C, 116A, 116B is formed by a stack of strips stacked along Z. Each strip extends along the direction Y, considered as the longitudinal direction. The length of the strips along Y can reach up to several hundreds meters.

Preferably, the semiconductor module 10, 110 comprises a plurality of semiconductor cells 16A, 16B, 16C, 116A, 116B for example a number of semiconductor cells greater than three. The semiconductor module 10, 110 preferably comprises four, nine or twenty semiconductor cells in the form of strips, the number of cells not being restricted to these values.

The semiconductor cells 16A, 16B, 16C, 116A, 116B are substantially identical and adjacent along the direction X. Each pair of adjacent semiconductor cells is connected by an electrical connection 17A, 17B, 117.

More specifically, in the embodiment of Figure 1, a first semiconductor cell 16A is adjacent along X to a second semiconductor cell 16B. Said second semiconductor cell 16B is positioned between the first 16A and a third 16C semiconductor cells. Said second semiconductor cell 16B is electrically connected to each of said first 16A and third 16C semiconductor cells, respectively by a first 17A and a second 17B electrical connections.

In the embodiment of Figure 2, a first semiconductor cell 116A is adjacent along X to a second semiconductor cell 116B. Said first 116A and second 116B semiconductor cells are electrically connected by an electrical connection 117.

The semiconductor cells 16A, 16B and 16C of the semiconductor module 10 are considered substantially identical to each other and will be generally designed by reference number 16. The semiconductor cells 116A, 116B of the semiconductor module 110 are considered substantially identical to each other and will be generally designed by reference number 116.

Moreover, the semiconductor cells 16 and 116 are similar, except for the differences detailed below, and will be described simultaneously.

The semiconductor cell 16, 116 comprises : a bottom electrode 18A, 18B, 18C ; a stack 20 of layers of materials, positioned on the bottom electrode 18A, 18B, 18C; and a top electrode 22, 122 positioned on the stack 20.

The bottom electrode 18A, 18B, 18C is part of a bottom layer 23 of a first electrically conductive material 24. The bottom layer 23 covers the surface 14 of the substrate 12. Preferably, said bottom layer 23 is transparent to visible light.

Preferably, the first electrically conductive material 24 is selected among the electrically conductive metals, the electrically conductive alloys, the electrically conductive polymers, the electrically conductive metal oxides and their combinations.

Examples of electrically conductive metals include gold, silver, copper, aluminum, nickel, palladium, platinum, and titanium.

Examples of electrically conductive alloys include stainless steel, alloys of gold, alloys of silver, alloys of copper, alloys of aluminum, alloys of nickel, alloys of palladium, alloys of platinum and alloys of titanium.

Examples of electrically conducting polymers include : polythiophenes, such as doped poly(3,4-ethylenedioxythiophene (doped PEDOT) ; polyanilines, such as doped polyanilines ; and polypyrroles, such as doped polypyrroles.

Examples of electrically conducting metal oxides include indium tin oxide (ITO), fluorinated tin oxide, tin oxide and zinc oxide. The electrically conductive metal oxides described above can be doped.

In an embodiment of the invention, the first electrically conductive material 24 comprises a multilayer material, such as an ITO/metal/ITO material or a dielectric/metal/dielectric material (DMD).

Preferably, the bottom layer 23 has a thickness along Z comprised between 10 nm and 150 nm.

The stack 20 is made of at least a functional layer 26 of a photoactive semiconductor material.

The photoactive semiconductor material is constituted of a mixture of an electron donor material (also called n-type material) and an acceptor of electrons material (also called p-type material). The semiconductor material is preferably selected among a molecule, an oligomer and a conjugated organic polymer. Thus, the photoactive semiconductor material may be a heterojunction with an electron donor material and an electron acceptor material.

In an embodiment, the photoactive semiconductor material comprises an organic electron donor material and an organic electron acceptor material.

Suitable organic electron donor materials include : conjugated polymers, such as polythiophenes, for example poly(3-hexylthiophene (P3HT) ; poly(phenylene-vinylene)s (PPVs) ; and small molecules, such as of DTS-(FBTTH2)2, IBTP, IDF, DTS-(PTTH2), borodipyromethene, diketopyrrolopyrrole, oligothiophene, indigo, quinacridone, merocyanin and squarain.

Suitable organic electron acceptor materials include fullerenes, especially substituted fullerenes such as [6,6]-phenyl C61-butyric acid methyl ester (C61-PCBM) and [6,6]-phenyl C71-butyric acid methyl ester (C71-PCBM).

Alternatively, the photoactive semiconductor material is made of an organic/inorganic hybrid material such as perovskite material.

According to an embodiment, the functional layer 26 is formed by a stack of at least two layers of different photoactive semiconductor materials, preferably chosen among the materials listed above.

Preferably, the functional layer 26 has a thickness along Z comprised between 250 nm and 500 nm.

According to a first alternative, the stack 20 is made only of the functional layer 26 of photoactive semiconductor material.

According to a second alternative, shown on Figures 1 and 2, the stack 20 is also made of a first 28 and a second 30 intermediate layers, the functional layer 26 being sandwiched along Z between said first 28 and second 30 intermediate layers.

The first intermediate layer 28 is situated between the bottom layer 23 and the functional layer 26. The first intermediate layer 28 is an electrically conductive layer made of semiconductor materials, such as Zinc Oxide (ZnO), Titanium Oxides (TiOx), cesium carbonate Cs2CO3, PolyEthylenlmine (PEI).

According to an embodiment, the first intermediate layer 28 is formed by a stack of at least two layers of different semiconductor materials, preferably chosen among the materials listed above.

Preferably, the first intermediate layer 28 has a thickness along Z comprised between 2 nm and 100 nm.

The second intermediate layer 30 is a hole transport layer. The second intermediate layer 30 is preferably made of semiconductor materials, such as poly(3,4-ethylenedioxythiophene) polystyrene sulfonate (PEDOT:PSS).

According to an embodiment, the second intermediate layer 30 is formed by a stack of at least two layers of different semiconductor materials.

Preferably, the second intermediate layer 30 has a thickness along Z comprised between 400 nm and 600 nm.

As detailed below, the second intermediate layer 30 is designed to be electrically conductive or electrically non-conductive. More specifically, in the following description, a second intermediate layer 30 considered as "conductive" has an electrical conductivity chosen over 20 Siemens per centimeter (S/cm). On the other hand, a second intermediate layer 30 considered as "non-conductive" has an electrical conductivity chosen below 20 Siemens per centimeter (S/cm).

The top electrode 22, 122 is positioned on the stack 20 of the semiconductor cell. According to the considered embodiment relative to said stack 20, the top electrode 22 is in contact with the functional layer 26 or with the second intermediate layer 30.

The top electrode 22, 122 is made of a top layer 31, 34 of a second electrically conductive material 32.

Examples of suitable second electrically conductive materials 32 include electrically conductive metals, electrically conductive alloys, electrically conductive polymers, and electrically conductive metal oxides, as described above for the first electrically conductive material 24.

Preferably, the top layer 31, 34 is transparent to visible light.

The alternative wherein the stack 20 comprises a second intermediate layer 30 is now considered.

In an embodiment, such as the second embodiment of Figure 2, the top electrode 122 forms a continuous layer 31 on the second intermediate layer 30. In said embodiment, the second intermediate layer 30 is selected for being non-conductive.

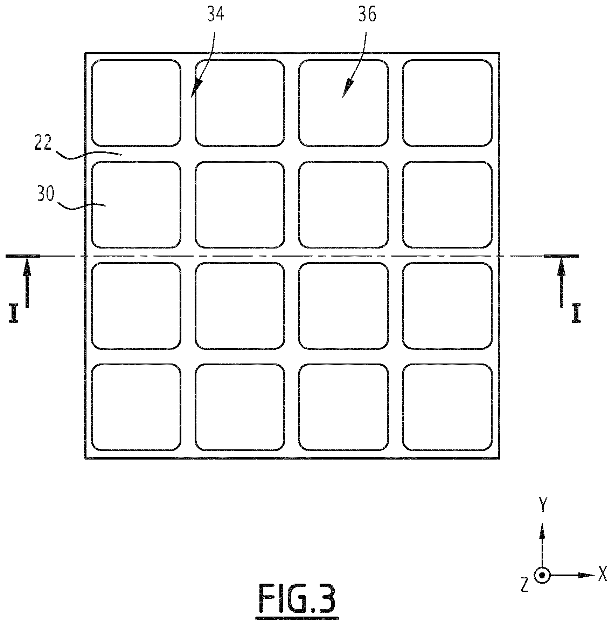

In another embodiment, such as the first embodiment of Figure 1, the top electrode 22 has the shape of a grid 34 extending in a (X, Y) plane, as shown on Figure 3. Said grid forms a conductive network of elementary pattern delimiting empty interior zones 36.

In the embodiment shown on Figure 3, the pattern of the grid 34 is composed of lines extending in the X and Y directions. According to another embodiment, the pattern of the grid 34 is composed of lines inclined with 45° angles toward the X and Y directions.

In the embodiment involving the grid 34, the second intermediate layer 30 is selected for being conductive.

Preferably, the top layer 31, 34 of second electrically conductive material 32 has a thickness comprised between 200 nm and 10 µm.

Each electrical connection 17A, 17B, 117 comprises : a conductive strip 38 ; a first 40, a second 42 and a third 44, 144 grooves ; and a connecting area 46, 146. In an embodiment, such as the first and second embodiments of Figures 1 and 2, each electrical connection 17A, 17B, 117 also comprises an insulating strip 48.

The electrical connections 17A and 17B are substantially identical and will be generally designed by reference number 17. The electrical connections 17, 117 will be described simultaneously, the common elements being designed by the same reference numbers.

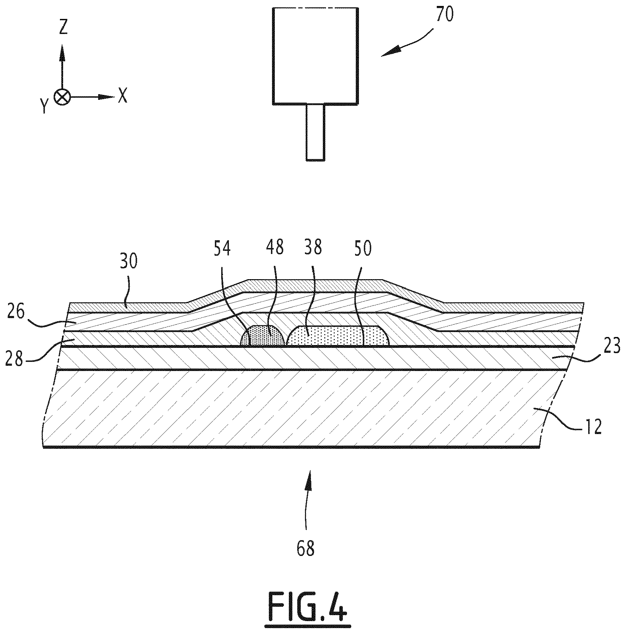

The conductive strip 38 of the electrical connection 17, 117 extends on the bottom layer 23 along the longitudinal direction Y. The conductive strip 38 covers a first portion 50 (Figure 4) of the bottom layer 23 along the transversal direction X. Preferably, a width of the conductive strip 38 along X is comprised between 0,1 mm and 0,8 mm.

The layers 26, 28, 30 forming the stack 20 extend over the conductive strip 38.

The conductive strip 38 is made of a third electrically conductive material 52. Examples of suitable third electrically conductive materials include electrically conductive metals, electrically conductive alloys, electrically conductive polymers, and electrically conductive metal oxides. Examples of electrically conductive metals include gold, silver, copper, aluminum, nickel, palladium, platinum, and titanium.

The optional insulating strip 48 of the electrical connection 17, 117 extends on the bottom layer 23 along the longitudinal direction Y. The insulating strip 48 covers a second portion 54 (Figure 4) of the bottom layer 23 along the transversal direction X. The second portion 54 is adjacent to the first portion 50 covered by the conductive strip 38 of the considered electrical connection 17, 117.

Preferably, a width of the insulating strip 48 along X is comprised between 100 µm and 1,5 mm. Preferably, a thickness of the insulating strip 48 along Z is comprised between 5 µm and 30 µm. More preferably, the thickness is about 15 µm.

The layers 26, 28, 30 forming the stack 20 extend over the insulating strip 48.

The insulating strip 48 is made of an insulating material. As detailed below, said insulating material is transparent to laser wavelengths.

Examples of suitable insulating materials are polymers prepared from monomeric materials such as amines, acrylates, epoxies, urethanes, or combinations thereof.

Each of the first 40, second 42 and third 44, 144 grooves of the electrical connection 17, 117 extends along the longitudinal direction Y. Said first, second and third grooves are parallel to each other and spaced from one another by a non-zero distance along the transversal direction X.

The first groove 40 is dug in at least the bottom layer 23 and has a non-zero width along X. In the embodiment of Figure 1, the first groove 40 of each electrical connection 17A, 17B electrically isolates the bottom electrodes of the adjacent semiconductor cells, respectively 16A, 16B and 16B, 16C, connected by said electrical connection. In the embodiment of Figure 2, the first groove 40 of the electrical connection 117 electrically isolates the bottom electrodes of the adjacent semiconductor cells 116A and 116B.

Preferably, the first groove 40 is spaced from the conductive strip 38 by a non-zero first distance 55 along the transversal direction X.

In an embodiment of the invention, as shown in Figures 1 and 2, the first groove 40 is also dug in the functional layer 26 and in the optional first 28 and second 30 intermediate layers. In the embodiment of Figure 1, the first groove 40 extends between the stacks 20 of the adjacent semiconductor cells, respectively 16A, 16B and 16B, 16C.

According to the embodiment of the invention wherein the electrical connection 17, 117 comprises an insulating strip 48, the first groove 40 does not extend in said insulating strip along the stacking direction Z. More specifically, in the embodiments of Figures 1 and 2, the first groove 40 comprises a bottom part 56, dug in the bottom layer 23, and a top part 58, dug in the functional layer 26 and in the first 28 and second 30 intermediate layers. Said bottom 56 and top 58 parts are separated by the insulating strip 48.

Preferably, the first groove 40 is centered on the insulating strip 48 according to the transversal direction X.

In another embodiment of the invention, not shown, the first groove 40 is dug only in the bottom layer 23 and not in the functional layer 26, nor in the optional first 28 and second 30 intermediate layers. Said functional layer 26 and optional first 28 and second 30 intermediate layers are continuous over the first groove 40.

In such an embodiment, the insulating strip 48 is unnecessary. As detailed below, in such an embodiment without an insulating strip 48, the first groove 40 may be filled by a non-conductive material also forming the functional layer 26 or the optional first intermediate layer 28.

The third groove 44, 144 is dug in the functional layer 26 and in the optional first 28 and second 30 intermediate layers. Moreover, as detailed below, the third groove 44 electrically isolates the top electrodes 22 of two adjacent semiconductor cells, respectively 16A, 16B and 16B, 16C ; in the same manner, the third groove 144 electrically isolates the top electrodes 122 of two adjacent semiconductor cells 116A and 116B.

The first 40 and third 44, 144 grooves are spaced along X by a non-zero second distance 60. Said second distance 60 is preferably comprised between 100 µm and 1000 µm.

The second groove 42 is dug in the functional layer 26 and in the optional first 28 and second 30 intermediate layers. The second groove 42 is situated along X between the first 40 and third 44, 144 grooves. The first 40 and second groove 42 are spaced along X by a non-zero third distance 62. Said third distance 62 is inferior to the second distance 60 and preferably comprised between 100 µm and 1000 µm.

The second groove 42 extends over the conductive strip 38 according to the stacking direction Z.

According to the first embodiment of Figure 1, wherein the second intermediate layer 30 is conductive, the third groove 44 is spaced from the conductive strip 38 by a non-zero fourth distance 64 along X.

According to the second embodiment of Figure 2, wherein the second intermediate layer 30 is non-conductive, the third groove 144 extends over the conductive strip 38 as well as the second groove 42. As an alternative of the embodiment of Figure 2, the third groove 144 may be spaced from the conductive strip 38 by a non-zero fourth distance 64 along X.

The connecting area 46 is made of a fourth electrically conductive material 66 (Fig. 2), filling the second groove 42 and, optionally, the top part 58 of the first groove 40.

Examples of suitable fourth electrically conductive materials 66 include electrically conductive metals, electrically conductive alloys, electrically conductive polymers, and electrically conductive metal oxides, as described above for the first 24 and second 32 electrically conductive materials.

In an embodiment, such as the first embodiment of Figure 1, the fourth electrically conductive material is identical to the second electrically conductive material 32.

The connecting area 46 of the electrical connection 17A, 17B, materialized by the fourth electrically conductive material filling the second groove 42, creates a low ohmic contact between the top electrode 22 of a semiconductor cell 16A, 16B and the bottom electrode 18B, 18C of the adjacent semiconductor cell. In the same manner, the connecting area 46 of the electrical connection 117 creates a low ohmic contact between the top electrode 122 of a semiconductor cell 116A and the bottom electrode 18B of the adjacent semiconductor cell 116B.

A method for manufacturing the semiconductor module 10, 110 will now be described, based on Figure 4. The method comprises : a first stacking step ; a second scribing step for forming the first 40 and second 42 grooves ; a third scribing step for forming the third groove 44, 144 ; and a fourth connecting step.

At the beginning of the first stacking step, the substrate 12 is provided, covered with the bottom layer 23 of the first electrically conductive material 24. The bottom layer 23 is deposited on the substrate 12 by known methods, appropriate to the selected material 24.

Then, for each intended electrical connection 17A, 17B, 117, a conductive strip 38 and an optional insulating strip 48 are deposited, respectively on the first 50 and second 54 portions of the bottom layer 23.

Then, in the embodiments of Figures 1 and 2, the first intermediate layer 28, the functional layer 26 and the second intermediate layer 30 are successively deposited on the bottom layer 23 and on the conductive 38 and insulating 48 strips. In another embodiment (not shown), the functional layer 26 is directly deposited on the bottom layer 23 and on the conductive 38 and insulating 48 strips.

Preferably, each of the conductive strip 38, insulating strip 48, first 28 and second 30 intermediate layers and functional layer 26 is deposited by a wet process, more preferably chosen among flexographic printing, rotary screen printing, slot-die coating and inkjet printing.

An intermediate state architecture 68, shown on Figure 4, is thus obtained.

According to a first embodiment of the method for manufacturing the semiconductor module 110 of Figure 2, the first stacking step further comprises an application of the top layer 31 on the second intermediate layer 30. Preferably, the top layer 31 is deposited by a wet process, more preferably chosen among flexographic printing, rotary screen printing, slot-die coating and inkjet printing.

In the second and third scribing steps of the method for manufacturing the semiconductor module 10, 110, the first 40, second 42 and third 44, 144 grooves are formed in the appropriate layers, as described above.

According to the invention, each groove 40, 42, 44, 144 is scribed by a laser source 70 at nanosecond range pulse duration. The laser source 70 is situated opposite the substrate 12 along the stacking direction Z.

By "nanosecond range pulse duration", it is meant that the pulse duration is inferior to 50 ns, more preferably inferior or equal to 20 ns.

As the insulating strip 48 is transparent to laser wavelength, the first groove is scribed in the bottom layer 23, functional layer 26, and first 28 and second 30 intermediate layers, without damaging said insulating strip 48.

The ablation threshold of each of the bottom layer 23, conductive strip 38, insulating strip 48, first 28 and second 30 intermediate layers and functional layer 26 is considered for the purpose of the present invention.

The ablation threshold of a material to be ablated is the minimum laser energy that enables the removal of the material. The ablation threshold can be determined with an experimental method first used by Liu, disclosed in [Xiao et. al., "Selective patterning of ITO on flexible PET substrate by 1064 nm picosecond laser." Physics Procedia 12 (2011): 125-132.].

In particular, during the scribing of the second groove 42 in the functional layer 26 and the first 28 and second 30 intermediate layers, the bottom layer 23 is protected by the conductive strip 38. Therefore, the architecture of the semiconductor module 10, 110 allows the use of a first electrically conductive material 24 with a comparatively low ablation threshold, such as silver nanowire. In the same manner, the materials and thicknesses of the functional layer 26 and the first 28 and second 30 intermediate layers may be associated with comparatively high ablation thresholds, without causing damage to the bottom layer 23 during the scribing of the second groove 42.

In an alternative of the second scribing step, the first 40 and second 42 grooves are formed successively with a same laser source. In another alternative of the second scribing step, the first 40 and second 42 grooves are formed simultaneously with two parallel laser sources.

In an embodiment of the invention, the third scribing step of forming the third groove 44, 144 is carried out before the fourth connecting step. For example, the second and third scribing steps are carried out successively, preferably with a same laser source. Alternatively, the first 40, second 42 and third 44, 144 grooves are formed simultaneously with three parallel laser sources.

In another embodiment of the invention, as described below, the third scribing step of forming the third groove 44, 144 is carried out after the fourth connecting step.

Preferably, the laser source 70 used for scribing each groove 40, 42, 44, 144 emits at a same wavelength and/or at a same frequency and/or at the same pulse duration.

Preferably, said same wavelength is comprised between 500 nm and 550 nm. For example, the laser source 70 used for scribing each groove 40, 42, 44, 144 emits at a wavelength of 532 nm.

Preferably, said same frequency is comprised between 20 kHz and 100 kHz and is for example of 40 kHz.

As mentioned above, the pulse duration of the laser source 70 is a nanosecond pulse duration. Preferably, the pulse duration is inferior or equal to 20 ns.

Advantageously, the scribing parameters of the laser source 70 are substantially identical for the second 42 and third 44, 144 grooves. Therefore, no parameter change is needed for successively scribing said second and third grooves with a same laser source 70.

In an embodiment, said scribing parameters of the laser source 70 for the first groove 40 are identical or close to those for the second 42 and third 44, 144 grooves. In the presence of an insulating strip 48, some parameters for the first groove and for the second and third grooves may be different.

In the fourth connecting step of the method for manufacturing the semiconductor module 10, 110, the second groove 42 is filled with fourth electrically conductive material 66, so as to form the connecting area 46, 146. Said connecting area creates a low ohmic contact between the top electrode 22, 122 of a semiconductor cell 16A, 116A and the bottom electrode of the adjacent semiconductor cell 16B, 116B. The semiconductor module 10, 110 is thus obtained.

According to the embodiment wherein the first stacking step comprises the formation of the top layer 31 on the second intermediate layer 30, the connecting area 146 forms an electrical connection with the top layer 31. The second 32 and fourth 66 electrically conductive materials may be identical or different.

According to other embodiments, the top layer 31, 34 is formed simultaneously with the connecting area 46, 146 during the fourth connecting step. In such embodiments, the second 32 and fourth 66 electrically conductive materials are preferably identical.

In a first alternative, the top layer 31, 34, formed simultaneously with the connecting area 46, 146, is applied in the shape of strips 72 (Figure 1). Each strip 72 extends along Y over a distinct bottom electrode 18A, 18B, 18C. Adjacent strips 72 are spaced by a non-zero interval 74 in the transversal direction X.

Preferably, in the case wherein the third groove 44, 144 has been formed before the fourth connecting step, the strips 72 are applied so that each third groove 44, 144 is situated in an interval 74 according to the transversal direction X.

In the case wherein a third groove 44, 144 has not been formed before the fourth connecting step, and if the second intermediate layer 30 is non-conductive, the third groove isolating adjacent top electrodes 22, 122 may be constituted by said interval 74. Therefore, in such a case, a laser-scribing step for forming the third groove is not necessary.

Moreover, in the first alternative, the strips 72 are optionally applied so that each first groove 40 is situated in an interval 74 according to the transversal direction X.

However, in the embodiment wherein an insulating strip 48 is provided on the bottom layer 23, it is possible to fill the top part 58 of the first groove 40 with the fourth electrically conductive material 66. The bottom part 56 of the first groove, protected by the insulating strip 48, remains free of conductive material. The electrical insulation of the bottom electrodes 18A, 18B, 18C is thus maintained.

In a second alternative, the top layer 31, 34, formed simultaneously with the connecting area 46, 146, is applied continuously over the different bottom electrodes 18A, 18B, 18C in the transversal direction X.

In said second alternative, it is preferable to carry out the third scribing step after the fourth connecting step. Thus, the third groove 44, 144 is formed in the top layer 31, 34, as well as in the functional layer 26 and optional intermediate layers 28, 30. Adjacent top electrodes 22, 122 are thereby isolated from one another.

For the reasons developed above, the insulating strip 48 allows the filling of the top part 58 of the first groove 40 with the fourth electrically conductive material 66, without compromising the insulation of the bottom electrodes 18A, 18B, 18C.

A method for manufacturing the semiconductor module according to the not-shown embodiment mentioned above, wherein the first groove 40 is dug only in the bottom layer 23, will now be described.

According to this method, the first groove 40 is scribed in the bottom layer 23 before depositing the functional layer 26 and the optional first 28 and second 30 intermediate layers. The conductive strip 38 is deposited on the first portion 50 of the bottom layer 23 before or after the scribing of the first groove 40 and before depositing said layers 26, 28, 30.

During the stacking step, the first groove 40 is filled with material forming the functional layer 26 or forming the first intermediate layer 28.

Then, the second and third grooves and the electrical connection of the electrodes are carried out in the same manner as in the previously described method.

The methods described above allows the scribing of the first 40, second 42 and optional third 44, 144 grooves with similar laser parameters, especially same wavelength and frequency. Therefore, it is possible to form the grooves successively with a same laser source 70, possibly without changing the parameters of said source.

Such a feature of the method allows an easy integration of laser patterning steps in a roll-to-roll manufacturing process.

The use of a nanosecond laser patterning system allows to produce industrial-scale modules with a high GFF (>90 %) and several meters length of monolithic interconnection. With functional modules, large scale processing and an overall high GFF, the manufacturing method according to the invention allows viable industrial production of OPV modules and other organic electronic devices.

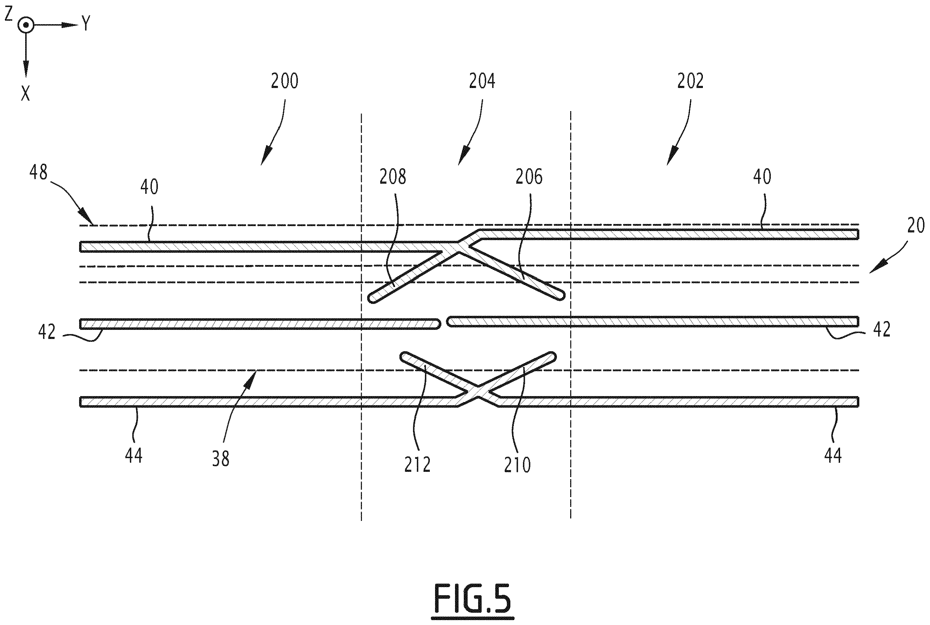

A particular embodiment of the method for manufacturing the semiconductor module 10, 110 will now be described, based on Figure 5.

For fully functional modules, at least the first 40 and third 44, 144 grooves need to be continuous in the longitudinal direction Y. In the embodiments wherein the first 40, second 42 and third 44, 144 grooves are formed successively with a same laser source 70, the scribing of the grooves is preferably decomposed in sections. More specifically, as shown on Figure 5, each groove 40, 42, 44 is scribed on a same first section 200 of the intermediate state architecture 68, and then each groove is scribed on a same second section 202 of said intermediate state architecture 68. The first 200 and second 202 sections are adjacent along the longitudinal direction Y. Such a pattern is repeated on the whole length of the semiconductor module 10 along Y.

There is a need to ensure the continuity of the first 40 and third 44 grooves, despite possible misalignments of the laser source 70 between the adjacent sections 200, 202. Accordingly, in the embodiment of Figure 5, the first 200 and second 202 sections are connected by a handover region 204.

In each handover region 204, the first 40 and third 44 grooves of each of the first 200 and second 202 sections are extended by an inclined end 206, 208, 210, 212.

Each inclined end 206, 208, 210, 212 extends substantially in a (X, Y) plane and forms a non-zero angle with the longitudinal direction Y.

The inclined ends 206 and 208 extend the first groove 40, respectively of the first 200 and of the second 202 sections. The inclined ends 206 and 208 are configured to intersect in the handover region 204, thereby ensuring the continuity of the first groove 40. Preferably, the inclined ends 206 and 208 extend toward the second groove 42.

The inclined ends 210 and 212 extend the third groove 44, respectively of the first 200 and of the second 202 sections. The inclined ends 210 and 212 are configured to intersect in the handover region 204, thereby ensuring the continuity of the third groove 44. Preferably, the inclined ends 210 and 212 extend toward the second groove 42.

During the scribing of the first 40 and third 44 grooves, the speed of the laser source 70 may be relatively low at the level of the inclined end 206, 208, 210, 212, because said source 70 would be in a slowing or accelerating phase relative to the substrate 12. As a consequence, if the light flux remains constant, the first and last laser pulses may possess higher power.

If the power exceeds the corresponding threshold values, such first and last laser pulses may damage the insulating strip 48 or the bottom layer 23 at the level of the inclined end 206, 208, 210, 212.

In order to avoid this damage, the inclined ends 206, 208, 210, 212 of a handover region 204 are preferably extending over the conductive strip 38. Indeed, said conductive strip is resilient against the laser beam.

### Experimental section

The intermediate state architecture 68 of Figure 4 was manufactured. The materials and thicknesses of the different layers are listed in Table 1 below :

**Table 1**

| **Layer** | **Material** | **Thickness (along Z)** |
|---|---|---|
| 12 | Polyethylene terephthalate | 125 µm |
| 23 (1^{st} embodiment) | Indium tin oxide | 100 nm |
| 23 (2^{nd} embodiment) | Ag nanowire | 100-200 nm |
| 28 | Zinc oxide | 35-50 nm |
| 26 | Photo-active layer | 250-500 nm |
| 30 | PEDOT:PSS | 600-800 nm |

Before applying the first intermediate layer 28 on the bottom layer 23, conductive strips 38 and isolating strips 48 were applied on said bottom layer 23. The materials, widths and thicknesses of the strip are listed in Table 2 below :

**Table 2**

| **Strip** | **Material** | **Width (along X)** | **Thickness** |
|---|---|---|---|
| 38 | Screen-printed Ag | 500 µm | 8 µm |
| 48 | Phenoxy resin | 500 µm | 15 µm |

The distance along X between two adjacent conductive strips 38 is 14 mm.

Then, a top layer 31, made of silver nanowire, was added on the intermediate state architecture 68. The thickness of the top layer 31 is of 200-500 nm.

Then, the first 40, second 42 and third 44, 144 grooves were successively scribed along Y by means of a same laser source 70. The laser source specifications are listed in Table 3 below :

**Table 3**

| | |
|---|---|
| **Wavelength** | 532 nm |
| **Operation frequency** | 40 KHz |
| **Pulse duration** | ≤ 20 ns |
| **Output power** | > 12,5 kW |

The speed along Y of the laser source 70 was 250 mm/s for the first groove 40 ; and 500 mm/s for the second 42 and third 44, 144 grooves.

The ablation thresholds of the different layers during the laser scribing of the grooves were considered. Experimental results are listed in Table 4 below :

**Table 4**

| **Layer** | **Ablation threshold (J/cm²)** | **Threshold pulse energy (µJ)** | **Threshold power at 40 Hz (mW)** |
|---|---|---|---|
| 28 + 26 + 30 | 0,09 | 12,6 | 504 |
| 31 | 0,14 | 17,6 | 704 |
| 23 | 0,36 | 51 | 2040 |
| 38 | 0,46 | 63 | 2520 |

The comparatively high ablation threshold of the conductive strip 38 gives more latitude for defining the laser scribing parameters, without damaging the bottom layer 23 during the scribing of the second groove 42.

After the scribing of the grooves 40, 42, 44, 144, a connecting area 46, 146 was formed in the first 40 and second 42 grooves by silver printing. The semiconductor module 10, 110 was thus obtained.

## Claims

1. A method for manufacturing a semiconductor module (10, 110), comprising at least two electrically connected semiconductor cells (16A, 16B, 16C, 116A, 116B), said semiconductor module comprising an insulating substrate (12) covered with a bottom layer (23) of a first electrically conductive material, each of the at least two semiconductor cells extending along a longitudinal direction (Y) of the insulating substrate ; the method comprising the following steps :
a) forming a conductive strip (38) on the bottom layer, said conductive strip extending along the longitudinal direction and covering a first portion (50) of the bottom layer along a transversal direction (X) perpendicular to the longitudinal direction ; then
b) depositing, on the bottom layer and conductive strip, a stack (20) comprising at least a functional layer (26) of a photoactive semiconductor material;
the method also comprising the following steps :
c) forming, in the bottom layer, a first groove (40) defining a first (18A) and a second (18B) bottom electrodes, electrically isolated from one another, said first groove being distant (55) from the conductive strip (38) ;
d) forming a second groove (42) in the stack (20), over the conductive strip ; said step d) being carried out after step b) ;
each of the first and second grooves extending along the longitudinal direction, said first and second grooves being parallel to each other and spaced from one another by a non-zero distance (62) along the transversal direction ;
each of the first and second grooves being formed by a laser source at nanosecond range pulse duration ;
and
e) depositing a top layer (22, 122) of a second electrically conductive material over the stack deposited on each of the first (18A) and second (18B) bottom electrodes,
so that each of said first (18A) and second (18B) bottom electrodes forms respectively a first (16A, 116A) and a second (16B, 116B) semiconductor cell with the top layer (22, 122) and stack (20) deposited over said bottom electrode ;
then
f) forming a connecting area (46, 146) between the top layer of the first semiconductor cell and the second bottom electrode, by printing a third electrically conductive material (66) into the second groove (42).

2. A method for manufacturing a semiconductor module according to claim 1,
wherein it comprises, before steps b) and c), a step i) of forming an insulating strip (48) of an electrically insulating material on the bottom layer ; said insulating strip extending along the longitudinal direction and covering a second portion (54) of the bottom layer perpendicularly to the longitudinal direction, said second portion being adjacent to the first portion (50) covered by the conductive strip ;
so that the stack (20) formed in step b) covers the bottom layer, the insulating strip and the conductive strip ; and so that, in step c), the first groove (40) is formed in the bottom layer (23) through the insulating strip (48).

3. A method for manufacturing a semiconductor module according to claim 2, wherein step c) is carried out after step b) and wherein, in step c), a part (58) of the first groove (40) is formed in the stack (20).

4. A method for manufacturing a semiconductor module according to any one of the preceding claims, also comprising a step g) of forming a third groove (44, 144) in the stack, said third groove extending along the longitudinal direction, said step g) being carried out after step b) ;
the first, second and third grooves being parallel to each other and spaced from one another by a non-zero distance along the transversal direction ;
the third groove (44, 144) being formed by a laser source at nanosecond range pulse duration.

5. A method for manufacturing a semiconductor module (110) according to claim 4, wherein step e) is carried out before step g) ; and wherein the third groove (144) is also formed in the top layer (122).

6. A method for manufacturing a semiconductor module (110) according to claim 5, wherein step e) is also carried out before steps c) and d) ; and wherein the first (40) and second (42) grooves are also formed in the top layer (122).

7. A method for manufacturing a semiconductor module (10) according to claim 4, wherein steps e) and f) are simultaneously carried out after steps c), d) and g) ; and wherein the second (32) and third (66) electrically conductive materials are preferably identical.

8. A method for manufacturing a semiconductor module (110) according to any one of claims 4 to 7, wherein, in step g), the third groove (144) is formed over the conductive strip (38).

9. A method for manufacturing a semiconductor module (10) according to any one of claims 4 to 7, wherein, in step g), the third groove (44) is formed at a non-zero distance (64) from the conductive (38) strip along the transversal direction.

10. A method for manufacturing a semiconductor module according to any one of the preceding claims, wherein the stack formed in step b) also comprises a first (28) and a second (30) intermediate layers, the functional layer (26) being sandwiched between said first and second intermediate layers.

11. A semiconductor module (10, 110) derived from a method according to any one of the preceding claims, said semiconductor module comprising at least two electrically connected semiconductor cells (16A, 16B, 16C, 116A, 116B) extending along a longitudinal direction (Y) ;
said semiconductor module comprising :
- an insulating substrate (12) ;
- a bottom layer (23) of a first electrically conductive material, covering the insulating substrate ;
- a first groove (40) formed in the bottom layer, defining a first (18A) and a second (18B) bottom electrodes ;
- a conductive strip (38) formed on the bottom layer, at a distance (55) from the first groove (40) along a transversal direction (X) perpendicular to the longitudinal direction;
- a stack (20) formed on the bottom layer and conductive strip, over each of the first (18A) and second (18B) bottom electrodes said stack comprising at least a functional layer (26) of a photoactive semiconductor material ;
- a second groove (42) formed in the stack, over the conductive strip ;
each of the first and second grooves extending along the longitudinal direction, said first and second grooves being parallel to each other and spaced from one another by a non-zero distance (62) along the transversal direction ;
- a top layer (22, 122) formed over the stack deposited over each of the first (18A) and second (18B) bottom electrodes,
so that each of said first (18A) and second (18B) bottom electrodes forms respectively a first (16A, 116A) and a second (16B, 116B) semiconductor cell with the top layer (22, 122) and stack (20) deposited over said bottom electrode ;
and
- a connecting area (46, 146) between the top layer of the first semiconductor cell and the second bottom electrode, said connecting area including a third electrically conductive material (66) filling the second groove (42).

12. The semiconductor module according to claim 11, also comprising an insulating strip (48) formed on the bottom layer, adjacent to the conductive strip (38),
the first groove (40) comprising a bottom part (56) in the bottom layer and a top part (58) in the stack (20), the insulating strip being situated between said bottom and top parts of the first groove.

13. The semiconductor module according to claim 11 or claim 12, wherein the first groove (40) comprises sections (200, 202) adjacent along the longitudinal direction, each pair of adjacent sections being connected by a handover region (204) so that, in said handover region, the first groove of each of the adjacent sections is extended by an inclined end (206, 208) forming a non-zero angle with the longitudinal direction, said inclined ends (206, 208) intersecting in the handover region, said inclined ends (206, 208) preferably extending over the conductive strip (38).

14. The semiconductor module according to any one of claims 11 to 13, also comprising a third groove (44, 144) formed in the stack, said third groove extending along the longitudinal direction ;
the first, second and third grooves being parallel to each other and spaced from one another by a non-zero distance along the transversal direction.

15. The semiconductor module according to claim 14, wherein the third groove (44) comprises sections (200, 202) adjacent along the longitudinal direction, each pair of adjacent sections being connected by a handover region (204) so that, in said handover region, the first groove of each of the adjacent sections is extended by an inclined end (210, 212) forming a non-zero angle with the longitudinal direction, said inclined ends (210, 212) intersecting in the handover region, said inclined ends (210, 212) preferably extending over the conductive strip (38).
